# EUROPEAN PATENT APPLICATION

(11) **EP 4 503 133 A1**
(43) Date of publication of application: **05.02.2025**
(21) Application number: 23868609.1
(22) Date of filing: 21.09.2023
(51) Int. Cl.: H01L 27/15, H01L 25/075, H01L 33/50, H01L 33/58, H01L 33/52, H01L 23/00

(54) **DISPLAY MODULE COMPRISING COLOR CONVERSION LAYER FORMED ON SELF-LUMINOUS DEVICE, AND MANUFACTURING METHOD THEREFOR**

(30) Priority: 21.09.2022 KR 20220119518
(71) Applicant: Samsung Electronics Co., Ltd., Suwon-si, Gyeonggi-do 16677 (KR)
(72) Inventor: LEE, Daehee, Suwon-si Gyeonggi-do 16677 (KR); KOH, Sungjun, Suwon-si Gyeonggi-do 16677 (KR); SOHN, Sanghyun, Suwon-si Gyeonggi-do 16677 (KR)
(74) Representative: Appleyard Lees IP LLP
(86) International application number: PCT/KR2023/014367
(87) International publication number: WO 2024/063557

(57) **Abstract**

Provided is a display module. The display module ncluding a substrate, and a plurality of pixels on the substrate, wherein each of the plurality of pixels includes a first self-luminescence element, a second self-luminescence element, and a third self-luminescence element configured to emit lights of a first wavelength band, respectively, a first color conversion layer configured to be disposed on the first self luminescence element, and comprise a plurality of first quantum dots to absorb the light of the first wavelength emitted from the first self-luminescence element, and emit a light of a second wavelength band and second color conversion layer configured to be disposed the second self luminescence element, and comprise a plurality of second quantum dots to absorb the light of the first wavelength emitted from the second self-luminescence element, and emit a light of a third wavelength band, wherein the first color conversion layer and the second color conversion layer comprise a plurality of foam particles configured to scatter the light emitted from the first self-luminescence element and the light emitted from the second self-luminescence element.

## Description

### [TECHNICAL FIELD]

Embodiments of the disclosure relate to a display module and a manufacturing method of the same, and more particularly, to a display module including to self-luminescence elements and color conversion layers formed on the self-luminescence elements, and a manufacturing method of the same.

### [BACKGROUND ART]

Recently, with the development of electronic technologies, use of a display module and a display device displaying an image by using quantum dots is increasing. Quantum dots absorb a light emitted by self-luminescence elements included in a display module, and then emit a light of a different wavelength area from the absorbed light. Here, quantum dots may be included in a color conversion layer formed on self-luminescence elements, and in the case of a display based on quantum dots, a plurality of scattering particles are included together within a color conversion layer including quantum dots. The plurality of scattering particles perform a role for scattering a light that is emitted without being absorbed into the quantum dots.

### [DISCLOSURE]

### [TECHNICAL SOLUTION]

According to an aspect of an embodiment, there is provided a display module including a substrate, and a plurality of pixels on the substrate, wherein each of the plurality of pixels includes a first self-luminescence element, a second self-luminescence element, and a third self-luminescence element respectively configured to emit a light of a first wavelength band, a first color conversion layer configured to be disposed on the first self luminescence element, and comprise a plurality of first quantum dots to absorb the light of the first wavelength emitted from the first self-luminescence element, and emit a light of a second wavelength band; and a second color conversion layer configured to be disposed the second self luminescence element, and comprise a plurality of second quantum dots to absorb the light of the first wavelength emitted from the second self-luminescence element, and emit a light of a third wavelength band, , wherein the first color conversion layer and the second color conversion layer include a plurality of foam particles configured to scatter the light emitted from the first self-luminescence element and the light emitted from the second self-luminescence element.

A diameter of each foam particle among the plurality of foam particles may be between 0.74µm and 1.26µm.
the plurality of foam particles may be foam particles of an inert gas.

A volume fraction of the plurality of foam particles for each of the first color conversion layer and the second color conversion layer may be between 5.3% and 9%.

Each of the first color conversion layer and the second color conversion layer may further include a plurality of scattering particles.

A mass ratio of the plurality of first quantum dots and the plurality of scattering particles included in the first color conversion layer may be between 1:0.04 and 1:0.14, and a mass ratio of the plurality of second quantum dots and the plurality of scattering particles included in the second color conversion layer may be between 1:0.04 and 1:0.14.

The first self-luminescence element, the second self-luminescence element, and the third self-luminescence element may be blue micro light emitting diodes.

The plurality of first quantum dots may be configured to absorb a light of a blue wavelength band and emit a light of a red wavelength band, and the plurality of second quantum dots may be configured to absorb a light of a blue wavelength band and emit a light of a green wavelength band.

The display module may further include a first color filter on the first color conversion layer, and a second color filter on the second color conversion layer.

The display module may further include a first transparent resin layer on the third self-luminescence element, and a second transparent resin layer on the first color conversion layer, wherein the second transparent resin layer, the first color filter, and the second color filter are on a same plane.

According to another aspect of an embodiment, there is provided a manufacturing method of a display module, the method including forming a first self-luminescence element, a second self-luminescence element, and a third self-luminescence element corresponding to a plurality of sub-pixels on a first substrate, forming a first color conversion layer and a second color conversion layer including a plurality of foam particles in areas corresponding to the first self-luminescence element and the second self-luminescence element among areas partitioned by a plurality of partitions formed on a second substrate, forming a transparent resin layer in an area corresponding to the third self-luminescence element among the areas partitioned by the plurality of partitions, and bonding the first substrate and the second substrate to each other, and bonding the plurality of color conversion layers to the first and second self-luminescence elements, and bonding the transparent resin layer to the third self-luminescence element, wherein the first color conversion layer includes a plurality of first quantum dots configured to absorb a light of a first wavelength emitted from the first self-luminescence element and emit a light of a second wavelength band, wherein the second color conversion layer includes a plurality of second quantum dots configured to absorb a light of the first wavelength emitted from the second self-luminescence element and emit a light of a third wavelength band, and wherein the light emitted from the first self-luminescence element and the light emitted from the second self-luminescence element are scattered by a plurality of foam particles included in the first color conversion layer and the second color conversion layer.

The manufacturing method may further include forming a plurality of black matrices at predetermined intervals on the second substrate, forming color filters among the plurality of black matrices formed on the second substrate, and forming partitions on each black matrix among the plurality of black matrices to correspond to the plurality of sub-pixels.

The manufacturing method may further include bonding the first substrate and the second substrate to each other such that the first color conversion layer corresponds to the first self-luminescence element, the second color conversion layer corresponds to the second self-luminescence element, and the transparent resin layer corresponds to the third self-luminescence element.

A diameter of each foam particle among the plurality of foam particles may be between 0.74µm and 1.26µm.

The plurality of foam particles may be foam particles of an inert gas.

### [DESCRIPTION OF DRAWINGS]

The above and other aspects, features, and advantages of embodiments of the disclosure will be more apparent from the following description taken in conjunction with the accompanying drawings, in which:
FIG. 1 is a schematic front view illustrating a display module according to an embodiment;
FIG. 2 is a schematic block diagram illustrating a display module according to an embodiment;
FIG. 3 is a cross-sectional view illustrating a single pixel of a display module including color conversion layers based on foam particles according to one or more embodiments;
FIG. 4 is a cross-sectional view illustrating a single pixel of a display module including color conversion layers based on foam particles and scattering particles according to one or more embodiments;
FIG. 5 is a diagram illustrating a luminance maintenance rate of a display module including color conversion layers based on foam particles according to one or more embodiments;
FIG. 6 is a schematic sequence diagram regarding a manufacturing method of a display module according to one or more embodiments;
FIG. 7 is a flow chart illustrating a manufacturing process of a first portion of a display module according to one or more embodiments;
FIG. 8 is a process diagram of a first portion of a display module according to one or more embodiments;
FIG. 9 is an exemplary diagram illustrating a method of manufacturing a first color conversion layer including a plurality of foam particles according to one or more embodiments;
FIG. 10 is a flow chart illustrating a manufacturing process of a second portion of a display module according to one or more embodiments;
FIG. 11 is a process diagram of a second portion of a display module according to one or more embodiments; and
FIG. 12 is a process diagram of coupling a first portion and a second portion of a display module according to one or more embodiments.

### [MODE FOR INVENTION]

First, terms used in this specification will be described briefly, and then the disclosure will be described in detail.

Embodiments described herein are example embodiments, and thus, the disclosure is not limited thereto.

As terms used in the embodiments of the disclosure, general terms that are currently used widely were selected as far as possible, in consideration of the functions described in the disclosure. However, the terms may vary depending on the intention of those skilled in the art, previous court decisions, or emergence of new technologies, etc. Also, in particular cases, there may be terms that were arbitrarily designated by the applicant, and in such cases, the meaning of the terms will be described in detail in the relevant descriptions in the disclosure. Accordingly, the terms used in the disclosure should be defined based on the meaning of the terms and the overall content of the disclosure, but not just based on the names of the terms.

Also, in this specification, expressions such as "have," "may have," "include," and "may include" denote the existence of such characteristics (e.g.: elements such as numbers, functions, operations, and components), and do not exclude the existence of additional characteristics.

In addition, the expression "at least one of A and/or B" should be interpreted to mean any one of "A" or "B" or "A and B."

Further, the expressions "first," "second," and the like used in this specification may describe various elements regardless of any order and/or degree of importance. Also, such expressions are used only to distinguish one element from another element, and are not intended to limit the elements.

Also, the description in the disclosure that one element (e.g.: a first element) is "(operatively or communicatively) coupled with/to" or "connected to" another element (e.g.: a second element) should be interpreted to include both the case where the one element is directly coupled to the another element, and the case where the one element is coupled to the another element through still another element (e.g.: a third element).

In addition, singular expressions include plural expressions, unless defined obviously differently in the context. Also, in the disclosure, terms such as "include" and "consist of" should be construed as designating that there are such characteristics, numbers, steps, operations, elements, components, or a combination thereof described in the specification, but not as excluding in advance the existence or possibility of adding one or more of other characteristics, numbers, steps, operations, elements, components, or a combination thereof.

Further, in the disclosure, "a module" or "a part" performs at least one function or operation, and may be implemented as hardware or software, or as a combination of hardware and software. Also, a plurality of "modules" or a plurality of "parts" may be integrated into at least one module and implemented as at least one processor (not shown), except "a module" or "a part" that needs to be implemented as specific hardware.

In the disclosure, a display module may be a display module including micro light emitting diodes ("micro LEDs") which are self-luminescence elements for displaying images. A display module is a kind of flat display panels, and it consists of a plurality of inorganic light emitting diodes (inorganic LEDs) each of which is smaller than or equal to 100 micrometers, and provides better contrast, response time, and energy efficiency than a liquid crystal display ("LCD") which needs a backlight. In a display module, as micro LEDs used for displaying images are self-luminescence elements, there is no need to include a separate backlight.

In the disclosure, micro LEDs which are inorganic LEDs have better brightness and light emitting efficiency, and a longer lifespan than organic LEDs ("OLEDs"). Micro LEDs may be semiconductor chips that may emit a light by themselves in case power is supplied. Micro LEDs have fast response speed, low power consumption, and high luminance. For example, micro LEDs have higher efficiency in converting electricity into photons than conventional LCDs or OLEDs. That is, micro LEDs have higher "brightness per watt" than a conventional LCD or OLED display. Accordingly, micro LEDs may exert identical brightness with about half the energy compared to conventional LEDs (of which length, width, and height respectively exceed 100µm) or OLEDs. Other than the above, micro LEDs may implement a high resolution, excellent colors, contrast, and brightness, and thus they may express colors in a wide range correctly, and may implement a clear screen outdoors. Also, micro LEDs are strong against a burn-in phenomenon and generate little heat, and thus a long lifespan without distortion is guaranteed. Micro LEDs may have a flip chip structure wherein an anode electrode and a cathode electrode are formed on the same first surface, and a light emitting surface is formed on a second surface positioned on the opposite side of the first surface wherein the electrodes are formed.

In the disclosure, one pixel may include at least three sub-pixels. One sub-pixel is a self-luminescence element for displaying images, and it may mean, for example, a micro LED, a blue micro light emitting diode (a blue LED), or an ultraviolet micro light emitting diode (a UV micro LED). Here, a blue micro LED is a self-luminescence element emitting a light of a blue wavelength band (450-490 nm), and a UV micro LED may be a self-luminescence element emitting a light of an ultraviolet wavelength band (360-410 nm).

In the disclosure, one sub-pixel may include one micro self-luminescence element and a color conversion layer and a color filter corresponding thereto together. The color conversion layer may be excited by a light emitted from the micro self-luminescence element and emit a color of a specific wavelength band. The color conversion layer may consist of a material including nanophosphors or quantum dots.

In the disclosure, one sub-pixel area means an area wherein a color of the sub-pixel is expressed by a light emitted from the sub-pixel. Also, in the disclosure, the area (the horizontal length × the vertical length) of one surface of a color conversion layer corresponding to a sub-pixel may be bigger than an area of the light emitting surface of the sub-pixel. In this case, the sub-pixel area may correspond to the area of the color conversion layer.

In the disclosure, a thin film transistor (TFT) layer on which a thin film transistor (TFT) circuit is formed may be disposed on the front surface of a substrate, and on the rear surface, a power supply circuit supplying power to the TFT circuit and a data driving driver, a gate driving driver, and a timing controller controlling each driving driver may be disposed. A plurality of pixels arrayed on the TFT layer may be driven by the TFT circuit.

In the disclosure, for a substrate, a glass substrate, a substrate based on a synthetic resin (e.g., polyimide (PI), polyethylene terephthalate (PET), polyethersulfone (PES), polyethylene naphthalate (PEN), polycarbonate (PC), etc.), or a ceramic substrate may be used.

In the disclosure, on the front surface of the substrate, a TFT layer on which a TFT circuit is formed may be disposed, and a circuit may not be disposed on the rear surface of the substrate. The TFT layer may be formed as an integrated body on the substrate, or may be manufactured in the form of a separate film, and attached on one surface of the glass substrate.

In the disclosure, the front surface of the substrate may be divided into an active area and a dummy area. The active area may correspond to the area occupied by the TFT layer on the front surface of the substrate, and the dummy area may be the area excluding the area occupied by the TFT layer on the front surface of the substrate.

In the disclosure, the edge area of the substrate may be the outermost area of the glass substrate. Also, the edge area of the substrate may be the remaining area excluding the area wherein the circuit of the substrate is formed. Further, the edge area of the substrate may include a part of the front surface of the substrate adjacent to the side surface of the substrate, and a part of the rear surface of the substrate adjacent to the side surface of the substrate. The substrate may be formed as a quadrangle type. For example, the substrate may be formed as a rectangle or a square. The edge area of the substrate may include at least one side among the four sides of the glass substrate.

In the disclosure, the TFTs constituting the TFT layer (or the backplane) are not limited to a specific structure or type. For example, the TFTs cited in the disclosure may also be implemented as oxide TFTs and Si TFTs (poly silicon, a-silicon), organic TFTs, graphene TFTs, etc. other than low-temperature polycrystalline silicon (LTPS) TFTs, and only a P-type (or an N-type) MOSFET may be manufactured in an Si wafer CMOS process and applied.

In the disclosure, the pixel driving method of the display module may be an active matrix (AM) driving method or a passive matrix (PM) driving method. The display module may form a pattern of wirings to which each micro LED is electronically connected according to the AM driving method or the PM driving method.

In the disclosure, in one pixel area, a plurality of pulse amplitude modulation (PAM) control circuits may be disposed. In this case, each sub-pixel disposed in one pixel area may be controlled by the corresponding PAM control circuit. Also, in one pixel area, a plurality of pulse width modulation (PWM) control circuits may be disposed. In this case, each sub-pixel disposed in one pixel area may be controlled by the corresponding PWM control circuit.

In the disclosure, in one pixel area, a plurality of PAM control circuits and a plurality of PWM control circuits may be disposed together. In this case, some of the sub-pixels disposed in one pixel area may be controlled by the PAM control circuits, and the others may be controlled through the PWM control circuits. Also, each sub-pixel may be controlled by a PAM control circuit and a PWM control circuit.

In the disclosure, the display module may include a plurality of side surface wirings having the thickness of a thin film that are disposed at specific intervals along the side surface of the TFT substrate.

In the disclosure, in the display module, a plurality of penetrating wiring members formed not to be exposed on the side surface of the TFT substrate may be provided instead of side surface wirings that are exposed on the side surface of the TFT substrate. Accordingly, a dummy area may be minimized on the front surface of the TFT substrate, and an active area may be maximized, and thus the display module may become bezeless, and the mounting density of micro LEDs for the display module may be increased.

In the disclosure, in case a plurality of display modules implementing a bezeless structure are connected, a multi-display device in a large size that may maximize an active area may be provided. In this case, as a dummy area in each display module is minimized, pitches among each pixel of display modules adjacent to each other may be formed to be maintained to be identical to the pitches among each pixel in a single display module. Accordingly, this may be a method that makes seams invisible in connecting portions among each display module.

In the disclosure, a driving circuit may be implemented by a micro IC that is disposed in a pixel area and controls the driving of at least 2n pixels. In case a micro IC is applied to a display module, only a channel layer connecting the micro IC and each micro LED may be formed instead of a TFT on a TFT layer (or a backplane).

In the disclosure, a display module may be installed and applied in a single unit on a wearable device, a portable device, a handheld device, and various kinds of electronic products or electronic devices that need displays, and it may also be applied to a display device such as a monitor for a personal computer (PC), a high-resolution TV and signage (or, digital signage), an electronic display, etc. as a matrix type through a plurality of assembly arrangements.

Hereinafter, the disclosure will be described in detail with reference to the accompanying drawings.

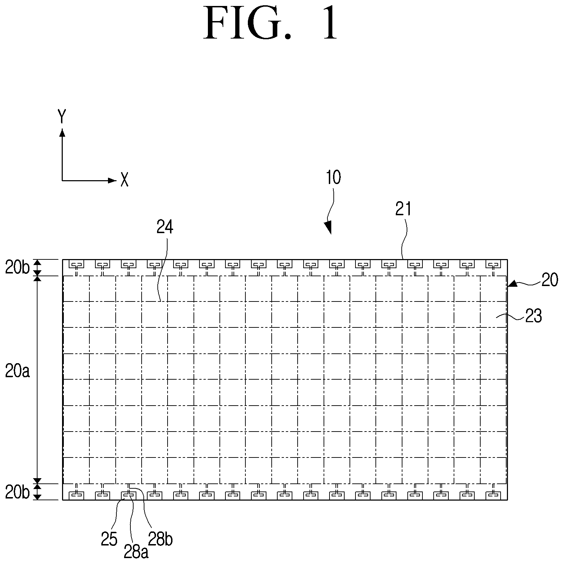

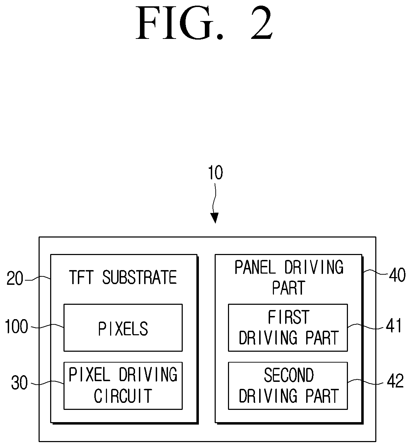

FIG. 1 is a schematic front view illustrating a display module according to an embodiment, and FIG. 2 is a schematic block diagram illustrating a display module according to an embodiment.

Referring to FIGS. 1 and 2, the display module 10 according to an embodiment may include a TFT substrate 20 on which a plurality of pixel driving circuits 30 are formed, a plurality of pixels 100 on the front surface of the TFT substrate 20, and a panel driving part 40 that generates a control signal and provides the generated control signal to the plurality of pixel driving circuits 30.

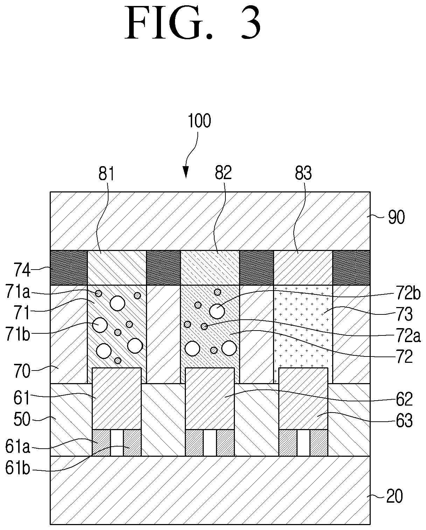

In the embodiment, one pixel may include a plurality of sub-pixels. Also, one sub-pixel may include one self-luminescence element and a color conversion layer and a color filter corresponding to each self-luminescence element. Here, the self-luminescence element is an inorganic self-light emitting diode, and for example, it may be a vertical cavity surface emitting laser (VCSEL) diode or a micro light emitting diode (LED) having a size of smaller than or equal to 100*µ*m (for example, smaller than or equal to 30*µ*m). A VCSEL diode and a micro LED may emit lights of a blue wavelength band (450-490 nm) or emit lights of an ultraviolet wavelength band (360-410 nm). The structure of the pixel 100 will be described in detail below with reference to FIG. 3.

The TFT substrate 20 may include a glass substrate 21, a TFT layer 23 including a thin film transistor (TFT) circuit on the front surface of the glass substrate 21, and a plurality of side surface wirings 25 that electronically connect the TFT circuit of the TFT layer 23 and circuits disposed on the rear surface of the glass substrate.

In the embodiment, as an alternative of the glass substrate 21, a substrate made of a synthetic resin that has a flexible material (e.g., polyimide (PI), polyethylene terephthalate (PET), polyethersulfone (PES), polyethylene naphthalate (PEN), polycarbonate (PC), etc.), or a ceramic substrate may be used.

The TFT substrate 20 may include an active area 20a providing images on the front surface, and a dummy area 20b that may not provide images.

The active area 20a may be partitioned into a plurality of pixel areas 24. The plurality of pixel areas 24 may be partitioned into various forms. For example, the plurality of pixel areas may be partitioned into a matrix form. In one pixel area 24, one pixel 100 (refer to FIG. 3) may be included.

The dummy area 20b may be included in the edge area of the glass substrate, and a plurality of connection pads 28a disposed at regular intervals may be formed along the edge area. Each of the plurality of connection pads 28a may be electronically connected with each pixel driving circuit 30 through a wiring 28b.

The number of the connection pads 28a formed in the dummy area 20b may vary according to the number of pixels implemented in the glass substrate 21, and may also vary according to the driving method of the TFT circuit disposed in the active area 20a. For example, compared to the case of a passive matrix (PM) driving method wherein the TFT circuit disposed in the active area 20a drives a plurality of pixels in a horizontal line and a vertical line, an active matrix (AM) driving method of independently driving each pixel may require more wirings and connection pads.

The TFT layer 23 may include a plurality of data signal lines disposed horizontally for controlling the plurality of pixels 100, a plurality of gate signal lines disposed vertically, and a plurality of pixel driving circuits 30 electronically connected with each line.

The panel driving part 40 may be directly connected with the substrate by a chip on glass (COG) or chip on plastic (COP) bonding method, or indirectly connected with the TFT substrate 20 through a separate FPCB by a film on glass (FOG) bonding method. The panel driving part 40 may drive the plurality of pixel driving circuits 30, and control light emission of a plurality of micro LEDs electronically connected with each of the plurality of pixel driving circuits 30.

The panel driving part 40 may control the plurality of pixel driving circuits 30 by each line through a first driving part 41 and a second driving part 42. The first driving part 41 may generate a control signal for sequentially controlling a plurality of horizontal lines formed on the TFT substrate 20 by one line per image frame, and transmit the generated control signal to the pixel driving circuits 30 respectively connected with the lines. The second driving part 42 may generate a control signal for sequentially controlling a plurality of vertical lines formed on the TFT substrate 20 by one line per image frame, and transmit the generated control signal to the pixel driving circuits 30 respectively connected with the lines.

FIG. 3 is a cross-sectional view illustrating a single pixel of a display module including color conversion layers based on foam particles according to one or more embodiments.

Referring to FIG. 3, one pixel 100 may be included in one pixel area 24 (refer to FIG. 1).

Each of the plurality of pixels 100 according to one or more embodiments may include a plurality of self-luminescence elements emitting lights of the same color. For example, the plurality of pixels 100 may include first, second, and third self-luminescence elements emitting lights of the first wavelength band.

According to one or more embodiments, the first, second, and third self-luminescence elements may be micro LEDs (the first, second, and third micro LEDs) respectively emitting lights of the blue wavelength band (450-490 nm). Here, each micro LED may correspond to each sub-pixel included in the pixel 100. As an example, the first sub-pixel of the pixel 100 may correspond to the first micro LED, the second sub-pixel may correspond to the second micro LED, and the third sub-pixel may correspond to the third micro LED. Hereinafter, explanation will be described by assuming the first, second, and third self-luminescence elements according to the disclosure as micro LEDs emitting lights of the blue wavelength band. Accordingly, the first self-luminescence element will be referred to as the first micro LED, the second self-luminescence element will be referred to as the second micro LED, and the third self-luminescence element will be referred to as the third micro LED.

The first micro LED 61 and the second micro LED 62 may be vertical cavity surface emitting laser (VCSEL) diodes such that lights are not emitted to the rear surfaces (the surfaces wherein chip electrodes are located) and the side surfaces of the first and second micro LEDs 61, 62, but are emitted only to the light emitting surfaces in a direction perpendicular to the surface of the TFT substrate 20.

The first to third micro LEDs 61, 62, 63 may be electronically and physically connected to the TFT substrate 20 through an anisotropic conductive film (ACF) 50 which was laminated on the front surface of the TFT substrate 20.

On the TFT substrate 20, an anisotropic conductive film may be formed. Here, the anisotropic conductive film 50 may include a thermosetting resin (an epoxy resin, a polyurethane resin, an acryl resin, etc.) and a plurality of conductive balls having relatively small diameters (e.g., 3-15*µ*m) inside the thermosetting resin. Each conductive ball may include polymer particles and a conductive film such as gold (Au), nickel (Ni), palladium (Pd), etc. coated on the surfaces of the polymer particles. The anisotropic conductive film 50 has conductivity in a compressing direction, and has an insulating property in a vertical direction of the compressing direction.

The first to third micro LEDs 61, 62, 63 may have a flip chip structure wherein two chip electrodes 61a, 61b which are an anode electrode and a cathode electrode are formed on the opposite side of the light emitting surface. The first and second chip electrodes 61a, 61b may consist of any one of aluminum (Al), titanium (Ti), chromium (Cr), Ni, Pd, silver (Ag), germanium (Ge), or Au, or an alloy thereof.

When the first to third micro LEDs 61, 62, 63 are transferred to the TFT substrate 20, they are seated on the surface of the anisotropic conductive film 50 attached on the TFT substrate 20. Then, through a thermo-compressing process, the first to third micro LEDs 61, 62, 63 are inserted into the inside of the anisotropic conductive film 50 as much as a predetermined depth. Accordingly, the first to third micro LEDs 61, 62, 63 may be physically fixed on the TFT substrate 20 by the anisotropic conductive film 50.

Also, as the first micro LED 61 is pressurized toward the TFT substrate 20 by the thermo-compressing process, the chip electrodes 61a, 61b of the first micro LED 61 may be positioned to be adjacent to the electrode pads of the TFT substrate 20. In this case, the chip electrodes 61a, 61b of the first micro LED 61 may be electronically connected with the substrate electrode pads by the conductive balls positioned between the chip electrodes 61a, 61b of the first micro LED 61 and the substrate electrode pads. Similarly, the second and third micro LEDs 62, 63 may also be electronically connected with the substrate electrode pads corresponding to each chip electrode through the conductive balls in the same manner as the first micro LED 61.

The first color conversion layer may be disposed on the first self-luminescence element. Here, the first color conversion layer includes a plurality of first quantum dots that absorb a light of the first wavelength band emitted from the first self-luminescence element and emit a light of the second wavelength band. Also, on the second color conversion layer may be disposed on the second self-luminescence element. Here, the second color conversion layer includes a plurality of second quantum dots that absorb a light of the first wavelength band emitted from the second self-luminescence element and emit a light of the third wavelength band.

For example, the first color conversion layer 71 includes a first quantum dot 71b that absorbs a light of the first wavelength band emitted from the first micro LED 61 and emits a light of the second wavelength band. Also, the second color conversion layer 72 includes a second quantum dot 72b that absorbs a light of the third wavelength band emitted from the second micro LED 62 and emits a light of the second wavelength band.

According to one or more embodiments, the first color conversion layer 71 may consist of a material including red quantum dots 71a that absorb a light of the blue wavelength band emitted from the blue micro LED 61 and emit a light of the red wavelength band. Also, the second color conversion layer 72 may consist of a material including green quantum dots that absorb a light of the blue wavelength band emitted from the blue micro LED and emit a light of the green wavelength band.

Here, a quantum dot may be a semiconductor particle in a small spherical shape in a size of nanometers (nm), and may have a size of approximately between 2nm and 10nm. A quantum dot may consist of a center body consisting of cadmium selenide (CdSe), cadmium telluride (CdTe), or cadmium sulfide (CdS), etc., and a surface consisting of zinc sulfide (ZnS).

According to the size of a quantum dot, an energy band gap between a valence band and a conduction band varies. For example, if the size of a quantum dot becomes smaller than the Bohr radius (e.g., if the size of a quantum dot becomes smaller to 10nm), the energy band gap increases due to a quantum confinement effect. As the energy band gap increases more, the quantum dot emits a light of a shorter wavelength. For example, according to the size of a quantum dot, the wavelength of a light emitted from the quantum dot may vary. Accordingly, the diameter of the red quantum dot 71a included in the first color conversion layer 71 may be approximately 7nm, and the diameter of the green quantum dot 72a included in the second color conversion layer 72 may be approximately 4nm.

Hereinafter, explanation will be described by assuming that a light of the second wavelength band is a red light, and a light of the third wavelength band is a green light, for the convenience of explanation of the disclosure.

The first and second color conversion layers 71, 72 may include nanophosphors that absorb lights emitted from the first and second micro LEDs 61, 62 and convert the lights into lights of different wavelength bands and emit the lights, as an alternative of the first and second quantum dots. Nanophosphors exhibit different physical properties compared to related phosphors of which particle diameters are scores of *µ*m. For example, as a gap of an energy band which is a quantum-state energy level structure of electrons inside crystals of a nanophosphor is big, the wavelength of an emitted light has high energy, and thus light emitting efficiency may be improved. In a nanophosphor, the particle density of the phosphor increases compared to a phosphor where the applied area has a bulk structure, and accordingly, colliding electrons effectively contribute to light emission, and thus the efficiency of the display may be improved.

The first color conversion layer 71 may include a red nanophosphor that is excited by a light of the blue wavelength band emitted from the first micro LED 61 and may emit a light of the red wavelength band. For example, the red nano phosphor may be SCASN (Si₁₋xCaₓAlSiN₃:Eu²⁺). In this case, the particle size distribution average value (d₅₀) of the red nanophosphor may be smaller than 0.5*µ*m (for example, 0.1*µ*m < d₅₀ < 0.5*µ*m).

The second color conversion layer 72 may include a green nanophosphor that is excited by a light of the blue wavelength band emitted from the second micro LED 62 and may emit a light of the green wavelength band. For example, the green nano phosphor may be β-SiAlON(Si_{6-z}Al_{z}O_{z}N_{8-z}:Eu²⁺) or SrGa₂S₄. In this case, the particle size distribution average value (d₅₀) of the green nanophosphor may be smaller than 0.5*µ*m (for example, 0.1*µ*m < d₅₀ < 0.5*µ*m).

Hereinafter, it will be explained that the first and second color conversion layers 71, 72 respectively include a plurality of red quantum dots and a plurality of green quantum dots, for the convenience of explanation of the disclosure.

The first transparent resin layer 73 may consist of a material that does not influence the transmittance, the reflectance, and the refractive index of a light emitted from the third micro LED 63, or that may minimize the transmittance, the reflectance, and the refractive index. The first transparent resin layer 73 may consist of various transparent resins such as polycarbonate (PC), polyether sulfone (PES), polymethyl methacrylate (PMMA), polyvinyl alcohol (PVA), polyimide (PI), etc. The first transparent resin layer 73 may be omitted depending on cases, and here, an air layer exists on the light emitting surface side of the third micro LED 63.

Each of the first and second color conversion layers 71, 72 includes a plurality of foam particles 71b, 72b for scattering lights respectively emitted from the first and second micro LEDs 61, 62. The plurality of foam particles 71b, 72b may be distributed inside the first and second color conversion layers 71, 72, and evenly scatter lights emitted from the first and second micro LEDs 61, 62 to the entire first and second color conversion layers 71, 72. For example, in order that lights emitted from the first and second micro LEDs 61, 62 are not absorbed into the quantum dots included in each of the first and second color conversion layers 71, 72 (i.e., the plurality of red quantum dots 71a included in the first color conversion layer 71 and the plurality of green quantum dots 72a included in the second color conversion layer 72) and are not emitted, the plurality of foam particles 71b, 72b scatter the lights emitted from each of the first and second micro LEDs 61, 62. Accordingly, luminance dispersion within the sub-pixel area may be reduced, and partial degradation in an area wherein lights are concentrated within the sub-pixel area may be prevented.

The plurality of foam particles 71b, 72b may be distributed according to a predetermined pattern, and scatter lights emitted from the first and second micro LEDs within a specific range.

The diameters of the plurality of foam particles 71b, 72b included in the first and second color conversion layers 71, 72 according to one or more embodiments may be, for example, between 0.74µm and 1.26µm.

Also, the plurality of foam particles 71b, 72b according to one or more embodiments may be foam particles of an inert gas. As an example, the plurality of foam particles 71b, 72b may be foam particles of an inert gas such as argon (Ar), nitrogen (N₂), etc.

In addition, the volume fraction of the plurality of foam particles 71b, 72b for each of the first and second color conversion layers 71, 72 may be, for example, between 2.5% and 9%. Here, the volume fraction may be the fraction of the total volume occupied by the plurality of foam particles in the volumes of the respective color conversion layers 71, 72. The volume fraction of the plurality of foam particles 71b, 72b may be determined based on the total volumes of the respective color conversion layers (the first color conversion layer 71 and the second color conversion layer 72), and the size, the number, etc. of the plurality of foam particles 71b, 72b included in the respective color conversion layers (the first color conversion layer 71 and the second color conversion layer 72).

According to the embodiments, the volume fraction of the plurality of foam particles 71b, 72b included in the respective color conversion layers 71, 72 may be set differently according to the wavelengths of lights emitted from the respective color conversion layers 71, 72. For example, the volume fraction of the plurality of foam particles 71b, 72b included in the first color conversion layer 71 and the volume fraction of the plurality of foam particles 71b, 72b included in the second color conversion layer 72 may be different.

For example, the volume fractions of the plurality of foam particles 71b, 72b respectively included in the first and second color conversion layers 71, 72 may be determined differently from each other based on the sizes of the quantum dots, etc. included in the first and second color conversion layers 71, 72. As an example, the volume fraction of the plurality of foam particles 71b in the first color conversion layer 71 including red quantum dots 71a having relatively larger sizes may be smaller than the volume fraction of the plurality of foam particles 72b in the second color conversion layer 72 including green quantum dots 72a having relatively smaller sizes. For example, the volume fractions of the plurality of foam particles 71b, 72b for the respective first and second color conversion layers 71, 72 may be set differently based on the wavelengths of lights emitted from the respective color conversion layers (i.e., the first and second color conversion layers 71, 72).

The first color conversion layer 71 may consist of a photocurable resin material. For example, the first color conversion layer 71 may be formed on the first micro LED 61 as a photocurable resin material including the plurality of red quantum dots 71a and the plurality of foam particles 71b is applied on the first micro LED 61, and is then cured. The second color conversion layer may also consist of a photocurable resin material, and may be formed on the second micro LED 62 in the same manner as the first color conversion layer 71. As an example, the photocurable resins of the first and second color conversion layers 71 and 72 may be epoxy, acrylate, methacrylate, urethane, and silane resins.

Also, the pixel 100 may include a first color filter 81 and a second color filter 82 respectively corresponding to the first and second color conversion layers 71 and 72, and include a second transparent resin layer 83 corresponding to the first transparent resin layer 73.

The first color filter 81 may be a red color filter that transmits a wavelength of a light of the same color as the color of a light of the red wavelength band emitted from the first color conversion layer 71. The second color filter 82 may be a green color filter that transmits a wavelength of a light of the same color as the color of a light of the green wavelength band emitted from the second color conversion layer 72.

The second transparent resin layer 83 may consist of a material that does not influence the transmittance, the reflectance, and the refractive index of a light that passed through the first transparent resin layer 73, or that may minimize them. Also, the second transparent resin layer 83 may be an optical film that makes the direction of a light toward the front surface through refraction and reflection, and may thereby minimize a wasted light and improve luminance.

The first to third micro LEDs 61, 62, 63 may be constituted as squares having a specific thickness and of which width and length are identical, or as rectangles of which width and length are different. Such micro LEDs may implement a real high dynamic range (HDR), and may improve luminance and expression of a black color, and may provide a relatively high contrast ratio compared to OLEDs. The sizes of the micro LEDs may be smaller than or equal to 100*µ*m, and for example, smaller than or equal to 30*µ*m.

Referring to FIG. 3 again, in the pixel 100, the light emitting areas of the first to third micro LEDs 61, 62, 63 may be partitioned by partition walls 70. The partition walls 70 may be formed of approximately lattice shapes. The plurality of light emitting areas partitioned by the partition walls 70 may respectively correspond to one sub-pixel area.

The upper ends of the partition walls 70 may adjoin the black matrix 74, and the lower ends of the partition walls 70 may adjoin the upper surface of the anisotropic conductive film 50. In each light emitting area partitioned by the partition walls 70, the first color conversion layer 71, the second color conversion layer 72, and the first transparent resin layer 73 may be disposed.

Accordingly, lights emitted to the side surface of the first color conversion layer 71 corresponding to the first micro LED 61 may be reflected by the partition walls 70, and emitted to the first color filter 81. Also, lights emitted to the side surface of the second color conversion layer 72 corresponding to the second micro LED 62 may be reflected by the partition walls 70, and emitted to the second color filter 82.

The partition walls 70 may have a white color having high light reflectance to function as reflecting bodies. Here, the white color may include true white and off-white. Off-white may include all colors similar to white.

The partition walls 70 may also be formed of a metallic material having a relatively high reflectance so that they may function as reflecting elements. Also, on the side surfaces of the partition walls 70, metal films having a relatively high light reflectance may be laminated.

The light emitting surfaces of the first to third micro LEDs 61, 62, 63 may be located at approximately the same height from the upper surface of the TFT substrate 20. Also, the light emitting surfaces of the first to third micro LEDs 61, 62, 63 may be located in positions higher than the lower ends of the partition walls 70. In this case, parts of the side surfaces of the first to third micro LEDs 61, 62, 63 may face the partition walls 70. Accordingly, lights emitted from the side surfaces of the first to third micro LEDs 61, 62, 63 may be reflected on the partition walls 70, and emitted to the first and second color conversion layers 71, 72 and the first transparent resin layer 73.

As described above, the partition walls 70 may reflect each of the lights emitted from the side surfaces of the first to third micro LEDs 61, 62, 63, lights emitted from the side surfaces of the first and second color conversion layers 71, 72, and a light emitted from the side surface of the first transparent resin layer 73, and emit the lights to the front surface of the display module 10, and may thereby maximize the light emitting efficiency.

A planarization layer may be disposed between the first and second color conversion layers 71, 72 and the first and second color filters 81, 82. Also, between the first transparent resin layer 73 and the second transparent resin layer 83, a planarization layer may be disposed.

The planarization layer may consist of a material that does not influence the transmittance, the reflectance, and the refractive index of lights that passed through the first and second color conversion layers 71, 72 and the first transparent resin layer 73, or that may minimize the transmittance, the reflectance, and the refractive index.

The space between the first and second color filters 81, 82 and the second transparent resin layer 83 may be partitioned by black matrices 74 formed in lattice shapes. The shapes of the black matrices 74 may be formed as lattice shapes so as to correspond to the shapes of the partition walls 70. In this case, the width of the black matrices 74 may be formed to be similar to the width of the partition walls 70.

On the upper side of the first and second color filters 81, 82 and the second transparent resin layer 83, a transparent cover layer 90 may be formed. The transparent cover layer 90 may prevent the pixel 100 from being polluted by a foreign substance, and may protect the pixel 100 from being damaged by an external force. To the transparent cover layer 90, a glass substrate may be applied.

In FIG. 3, only the parts wherein the partition walls 70, the black matrices 74, and the transparent cover layer 90 correspond to one pixel unit are illustrated, but the partition walls 70, the black matrices 74, and the transparent cover layer 90 may be formed in sizes that approximately correspond to the size of the TFT substrate 20.

The sizes of the first to third micro LEDs 61, 62, 63 are respectively formed to be smaller than the sizes of the first and second color conversion layers 71, 72 and the first transparent resin layer 73. Accordingly, a gap may be formed between the side surfaces of the first to third micro LEDs 61, 62, 63 and the partition walls 70.

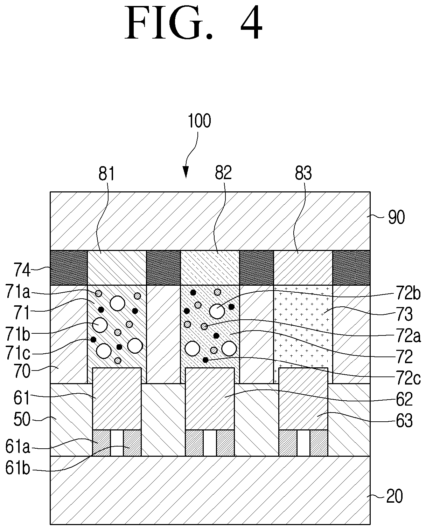

FIG. 4 is a cross-sectional view illustrating a single pixel of a display module including color conversion layers based on foam particles and scattering particles according to one or more embodiments. In explaining the display module illustrated in FIG. 4, regarding the same components as those of the display module 10 described above based on FIG. 3, the same reference numerals will be given, and explanation will be omitted.

Referring to FIG. 4, the first and second color conversion layers 71, 72 may further include a plurality of scattering particles. For example, the plurality of light scattering particles 71c, 72c respectively included in the first and second color conversion layers 71, 72 may consist of titanium dioxide (TiO₂), silicon dioxide (SiO₂), zirconium oxide (ZrO), or glass beads, etc. The plurality of light scattering particles may be distributed inside the first and second color conversion layers 71, 72, and evenly disperse lights emitted from the first and second micro LEDs 61, 62 to the entire first and second color conversion layers 71, 72 together with the plurality of foam particles 71b, 72b.

Hereinafter, the plurality of scattering particles included in the first color conversion layer 71 will be referred to as the first scattering particles 71c, and the plurality of scattering particles included in the second color conversion layer 72 will be referred to as the second scattering particles 72c.

According to one or more embodiments, the mass ratio of the plurality of red quantum dots 71a and the plurality of scattering particles included in the first color conversion layer 71 may be between 1:0.04 and 1:0.14. For example, the total mass ratio of the plurality of red quantum dots 71a included in the first color conversion layer 71 and the total mass ratio of the plurality of scattering particles included in the first color conversion layer 71 may be between 1:0.04 and 1:0.14.

Similarly, the mass ratio of the plurality of green quantum dots 72a and the plurality of scattering particles included in the second color conversion layer 72 may be between 1 :0.04 and 1 :0.14. For example, the total mass ratio of the plurality of green quantum dots 72a included in the second color conversion layer 72 and the total mass ratio of the plurality of scattering particles included in the second color conversion layer 72 may be between 1:0.04 and 1:0.14.

According to one or more embodiments, the mass ratios of the plurality of quantum dots (the first and second quantum dots 71a, 72a) and the plurality of scattering particles 71c, 72c included in the respective color conversion layers (the first and second color conversion layers 71, 72) may be set differently according to the wavelengths of lights emitted from the quantum dots. For example, the mass ratio of the plurality of red quantum dots 71a and the plurality of first scattering particles included in the first color conversion layer 71 may be different from the mass ratio of the plurality of green quantum dots 72a and the plurality of second scattering particles included in the second color conversion layer 72. This is because the number of the plurality of scattering particles (the first and second scattering particles 71c, 72c) included in the respective color conversion layers (the first and second color conversion layers 71, 72) may be determined based on the sizes, the number, etc. of the plurality of quantum dots (the first and second quantum dots 71a, 72a) included in the respective color conversion layers (the first and second color conversion layers 71, 72).

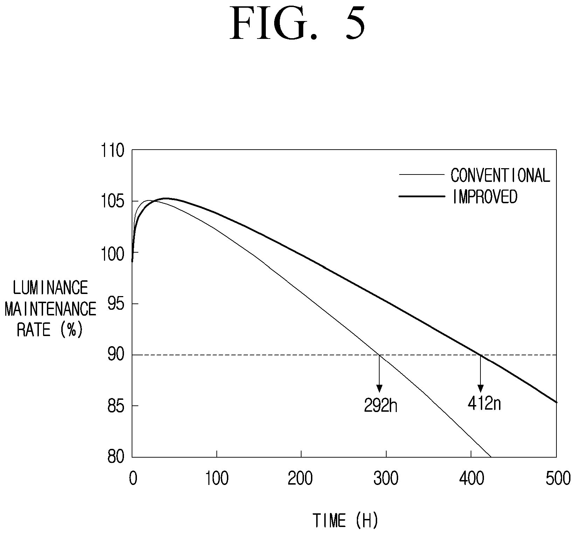

FIG. 5 is a diagram illustrating a luminance maintenance rate of a display module including color conversion layers based on foam particles according to one or more embodiments.

Referring to FIG. 5, compared to a related display module that scatters a light that permeated a color conversion layer by using only related scattering particles, in the case of the display module according to the disclosure that scatters a light that permeated a color conversion layer by using the plurality of foam particles 71b, 72b, the display module has a luminance maintenance rate of greater than or equal to 90% for a longer time. In this regard, in the case of a related display module that scatters a light that permeated a color conversion layer by using only related scattering particles, the mass ratio of the plurality of quantum dots and the plurality of scattering particles inside the color conversion layer was 1 :0.22. Here, in the related display module, loss of a blue light occurred as the plurality of scattering particles absorbed a blue light emitted from the luminescence elements. In addition, as radicals are generated from the scattering particles that absorbed a blue light, the surfaces of the quantum dots were damaged by the generated radicals. Due to this, the light conversion efficiency of the plurality of quantum dots inside the color conversion layer also decreased as time passed. However, the display module according to the embodiment may include a plurality of foam particles inside a color conversion layer and includes a plurality of scattering particles in a smaller amount than a related display module, and may thereby reduce the loss rate of a blue light by the plurality of scattering particles, and reduce the surface damage of the quantum dots by radicals, and may thus make the luminance maintained for a longer time.

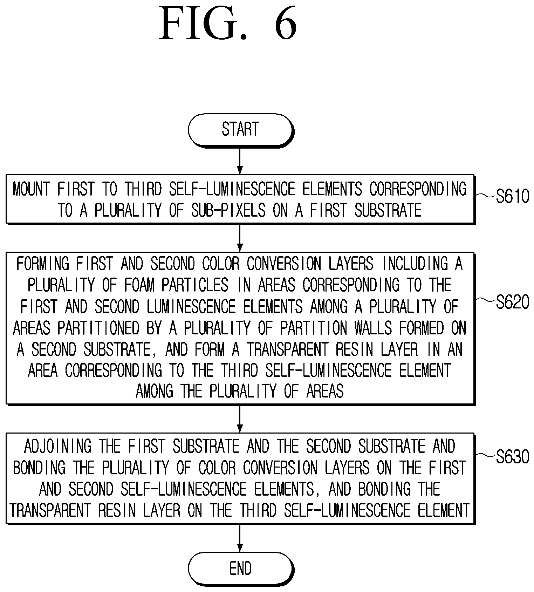

FIG. 6 is a schematic sequence diagram regarding a manufacturing method of a display module according to one or more embodiments of the disclosure.

Referring to FIG. 6, first, first to third self-luminescence elements corresponding to a plurality of sub-pixels are mounted on a substrate in operation S610.

The first substrate may be implemented as a TFT substrate 20 on which a plurality of pixel driving circuits 30 are formed. The first to third self-luminescence elements may be micro LEDs 61, 62, 63 emitting lights of a blue wavelength band (450-490 nm). Each micro LED 61, 62, 63 may correspond to each sub-pixel included by the pixel 100. As an example, the first sub-pixel of the pixel 100 may correspond to the first micro LED, the second sub-pixel may correspond to the second micro LED, and the third sub-pixel may correspond to the third micro LED.

Then, first and second color conversion layers 71, 72 including a plurality of foam particles 71b, 72b are formed in areas corresponding to the first and second self-luminescence elements among areas partitioned by a plurality of partition walls formed on a second substrate, and a transparent resin layer is formed in an area corresponding to the third self-luminescence element among the areas partitioned by the plurality of partition walls in operation S620.

The second substrate may be the transparent cover layer 90 illustrated in FIG. 3. For example, the second substrate may be implemented as a glass substrate. In the area corresponding to the first micro LED 61 among the plurality of areas partitioned by the plurality of partition walls formed on the glass substrate, the first color conversion layer 71 may be formed, and in the area corresponding to the second micro LED 62 among the plurality of areas, the second color conversion layer 72 may be formed.

Here, the first color conversion layer 71 may consist of a material including red quantum dots 71a that absorb a light of the blue wavelength band and emit a light of the red wavelength band. Also, the second color conversion layer 72 may consist of a material including green quantum dots 72a that absorb a light of the blue wavelength band and emit a light of the green wavelength band.

Each of the first and second color conversion layers 71, 72 may include a plurality of foam particles 71b, 72b for scattering lights of the blue wavelength band respectively emitted from the first and second micro LEDs 61, 62. Due to this, the lights of the blue wavelength band respectively emitted from the first and second self-luminescence elements may be scattered by the plurality of foam particles 71b, 72b included in the first and second color conversion layers 71, 72.

The first color conversion layer 71 may consist of a photocurable resin material. The photocurable resin material including the plurality of red quantum dots 71a and the plurality of foam particles 71b may be applied in the area corresponding to the first micro LED 61 among the plurality of areas partitioned by the plurality of partition walls, and the applied curable material may be cured by irradiating a light. Here, as the applied curable material is cured, the first color conversion layer 71 may be formed on the first micro LED 61. The second color conversion layer may also consist of a photocurable resin material, and may be formed on the second micro LED 62 in the same manner as the first color conversion layer 71.

Here, according to one or more embodiments, a plurality of scattering particles may be further included in the first and second color conversion layers 71, 72. For example, in the first color conversion layer 71, a plurality of first scattering particles that scatter a light of the blue wavelength band emitted from the first micro LED 61 may be further included, and in the second color conversion layer 72, a plurality of second scattering particles that scatter a light of the blue wavelength band emitted from the second micro LED 62 may be further included.

Here, according to one or more embodiments, the mass ratio of the plurality of first quantum points 71a and the plurality of scattering particles 71c included in the first color conversion layer 71 may be between 1:0.04 and 1:0.14, and the mass ratio of the plurality of second quantum points 72a and the plurality of scattering particles 72c included in the second color conversion layer 72 may be between 1:0.04 and 1:0.14.

After the first and second color conversion layers 71, 72 and the transparent resin layer 73 are formed in operation S620, the first substrate and the second substrate are adjoined, and the plurality of color conversion layers (the first and second color conversion layers 71, 72) are bonded to the first and second self-luminescence elements 61, 62, and the transparent resin layer 73 is bonded to the third self-luminescence element 63 in operation S630. Here, by pressurizing the second substrate to the side of the first substrate, the plurality of color conversion layers may be bonded to the first and second self-luminescence elements, and the transparent resin layer may be bonded to the third self-luminescence element.

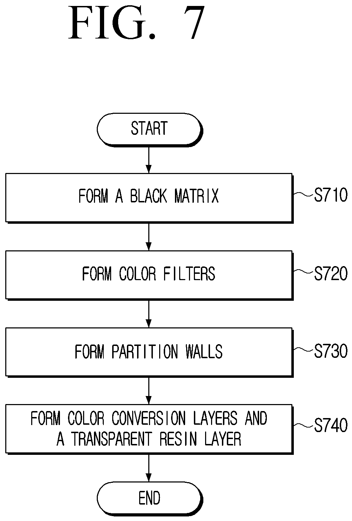

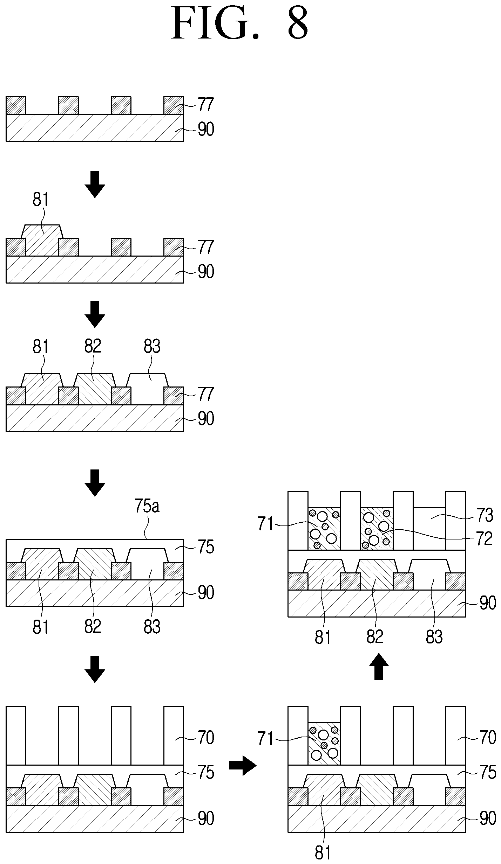

FIG. 7 is a flow chart illustrating a manufacturing process of a first portion of a display module according to one or more embodiments, and FIG. 8 is a process diagram of a first portion of a display module according to one or more embodiments. In FIG. 8, the entire first portion of the display module 10 is not illustrated, but a part corresponding to one pixel will be illustrated in an enlarged size.

Referring to FIG. 7 and FIG. 8, the first portion of the display module 10 may be manufactured through the order as follows. Here, the first portion may be a portion including the black matrix disposed on the second substrate in the display module 10, the first and second color conversion layers 71, 72, the first and second transparent resin layers, the first to third color filters, and the partition walls, and it may be a portion constituting the upper surface or the upper plate of the display module 10.

First, a black matrix 74 is formed in a lattice shape on one surface of the transparent cover layer 90 in operation S710.

As an example, for the transparent cover layer 90, a square or rectangle glass substrate having a specific thickness may be used. The size of the transparent cover layer 90 may approximately correspond to the size of the TFT substrate 20.

The black matrix 74 forms a plurality of cells as it is constituted as a lattice shape, and each cell may be a sub-pixel area. Similarly, a color filter is formed in a predetermined cell among the plurality of cells of the black matrix 74 in operation S720.

For example, for forming a first color filter 81, a red material is evenly applied on overall one surface of the transparent cover layer 90 wherein the black matrix 74 is formed. Then, only an area wherein the red color should remain is exposed by using a mask, and in the remaining areas, the red material is removed through development.

Then, for forming a second color filter 82, a green material is evenly applied on overall one surface of the transparent cover layer 90. Then, only an area wherein the green color should remain is exposed by using a mask, and in the remaining areas, the green material is removed through development.

Lastly, for forming a second transparent resin layer 83, a transparent resin material is evenly applied on overall one surface of the transparent cover layer 90. Then, only an area wherein the transparent resin should remain is exposed by using a mask, and in the remaining areas, the transparent resin material is removed through development.

As a method of applying a color filter material and a transparent resin material on the transparent cover layer 90, a slit method of evenly coating the material on the entire surface by using a printer nozzle, a spin method of spraying a liquid in the center, and then applying the liquid by rotating the plate, etc. may be applied.

When the first and second color filters 81, 82 and the second transparent resin layer 83 are formed, partition walls 70 in lattice shapes are formed on the upper surface of the black matrix in operation S730. Each cell formed by the partition walls 70 may be formed in locations corresponding to each cell formed by the aforementioned black matrix 74. In this case, each cell formed by the partition walls 70 corresponds to a sub-pixel area.

Depending on the embodiments, a process of forming a planarization layer 75 covering the first and second color filters 81, 82 and the second transparent resin layer 83 may be performed such that the partition walls 70 may be laminated on the black matrix. The upper surface of the planarization layer 75 has flatness to a degree that the partition walls 70 may be formed of uniform heights. The planarization layer 75 may be formed of a transparent material that does not influence the transmittance, the reflectance, and the refractive index of a light. Depending on the embodiments of the disclosure, the planarization layer 75 may not be included in the display module 10, and a process of forming the planarization layer 75 may also be omitted.

After the partition walls 70 are formed, the first color conversion layer 71 and the second color conversion layer 72 are sequentially patterned by applying a color conversion material (a quantum dot material) to each cell through an inkjet printing method in operation S740.

As another method of forming the first and second color conversion layers 71, 72, the color conversion layers may be formed by mixing a quantum dot material to a photoresist, and through applying, exposing, and developing in a similar way to the aforementioned manufacturing process of a color filter.

The first color conversion layer 71 may consist of red quantum dots 71a that ma emit lights of the red wavelength band, and the second color conversion layer 72 may consist of green quantum dots 72a that may emit lights of the green wavelength band.

Each of the first and second color conversion layers 71, 72 may include a plurality of foam particles for scattering lights of the blue wavelength band respectively emitted from the first and second micro LEDs 61, 62.

Here, according to one or more embodiments, the diameter of any one foam particle among the plurality of foam particles may be between 0.74µm and 1.26µm.

Also, according to one or more embodiments, the plurality of foam particles may be foam particles of an inert gas. As an example, the plurality of foam particles may be implemented as foam particles such as Ar, N₂, etc.

According to one or more embodiments, the volume fraction of the plurality of foam particles for each of the first and second color conversion layers 71, 72 may be between 5.3% and 9%. For example, the volume occupied by the plurality of foam particles 71b in the total volume of the first color conversion layer 71 may be between 5.3% and 9%.

After the first and second color conversion layers 71, 72 are patterned to each cell, a transparent resin material is patterned to empty cells wherein the first and second color conversion layers 71, 72 are not formed through an inkjet printing method, and the first transparent resin layer 73 is thereby formed.

Through the process as above, the first portion constituting the upper plate of the display module 10 may be formed.

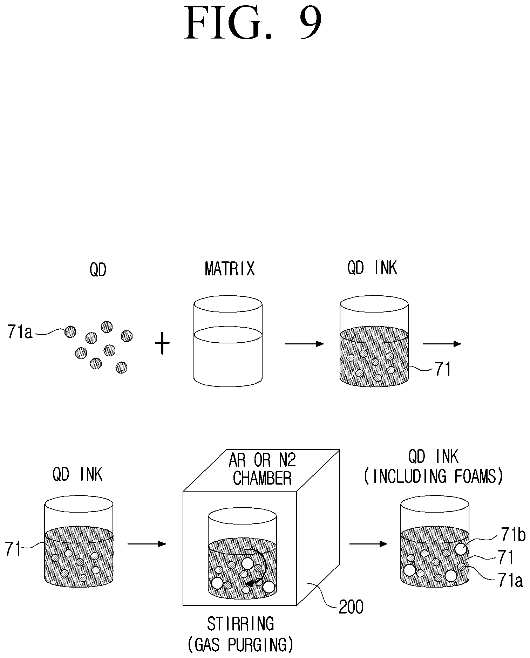

FIG. 9 is an exemplary diagram illustrating a method of manufacturing a first color conversion layer including a plurality of foam particles according to one or more embodiments of the disclosure.

Referring to FIG. 9, the plurality of red quantum dots 71a and the photocurable resin material are mixed inside a chamber 200 including an inert gas. For example, a process of, after including the plurality of red quantum dots 71a in the photocurable resin material, seating the curable material including the plurality of red quantum dots 71a inside the chamber including the inert gas, and then stirring the curable material including the plurality of red quantum dots 71a is performed. By this, the plurality of foam particles 71b of an inert gas may be generated in the curable resin material. The inert gas may be a gas such as Ar, N₂, etc. The aforementioned method is applied identically to the case of the second color conversion layer, and the plurality of foam particles 72b may be generated inside the curable resin material constituting the second color conversion layer.

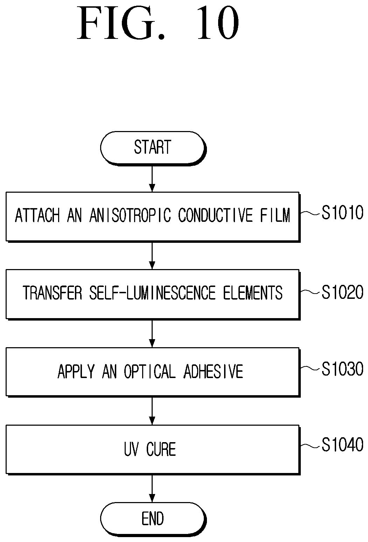

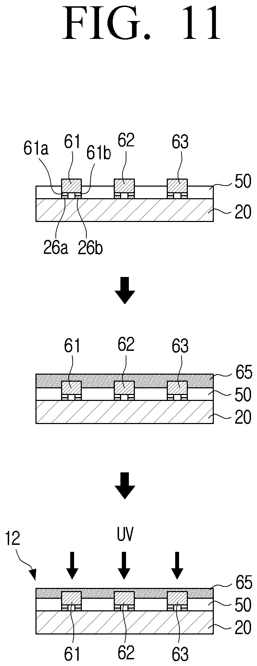

FIG. 10 is a flow chart illustrating a manufacturing process of a second portion of a display module according to one or more embodiments, and FIG. 11 is a process diagram of a second portion of a display module according to one or more embodiments. In FIG. 11, the entire second portion of the display module 10 is not illustrated, but a part corresponding to one pixel will be illustrated in an enlarged size. Here, the second portion is a portion including a plurality of self-luminescence elements on the first substrate in the display module 10, and it may be a portion constituting the lower surface or the lower plate of the display module 10.

Referring to FIG. 10 and FIG. 11, an anisotropic conductive film 50 is laminated on the front surface of the TFT substrate 20 in operation S 1010. In this case, on the front surface of the TFT substrate 20, a plurality of substrate electrode pads 26a, 26b are arrayed at regular intervals.

After the anisotropic conductive film 50 is attached on the TFT substrate 20, a plurality of micro LEDs are transferred to the TFT substrate 20 in operation S 1020. The transfer process of micro LEDs may be performed through a laser transfer method, a rollable transfer method, a pick and place transfer method, etc. In this case, the first to third micro LEDs 61, 62, 63 are respectively transported from an epi substrate to a relay substrate (or an interposer), and are then transferred from each relay substrate to the TFT substrate 20 which is the target substrate.

When the first to third micro LEDs 61, 62, 63 are transferred to the TFT substrate 20, they are seated on the surface of the anisotropic conductive film 50 attached on the TFT substrate 20. In this state, the first to third micro LEDs 61, 62, 63 are inserted into the inside of the anisotropic conductive film 50 as much as a predetermined depth through a thermo-compressing process. Accordingly, the first to third micro LEDs 61, 62, 63 are physically fixed on the TFT substrate 20. Also, chip electrodes of each micro LED 61, 62, 63 may be electronically connected with corresponding substrate electrode pads by a plurality of conductive balls distributed inside the anisotropic conductive film 50.

The first to third micro LEDs 61, 62, 63 may be blue micro LEDs emitting lights of the blue wavelength band.

Then, an optical adhesive 65 for bonding the first portion to the second portion is applied on the front surface of the TFT substrate 20 in operation S1030.

The optical adhesive 65 is applied on the TFT substrate 20 such that the optical adhesive 65 may cover all of the plurality of micro LEDs 61, 62, 63. The optical adhesive 65 may be UV-curable silicone rubber (chemical name: Di-methyl siloxane) that has a characteristic of being cured after a specific time after exposure to UV

Then, the optical adhesive 65 is cured by irradiating UV on the optical adhesive 65 during a predetermined time in operation S1040.

Through the process as above, the second portion constituting the lower plate of the display module 10 may be formed.

Hereinafter, a process of manufacturing the display module 10 by bonding the first portion and the second portion with each other will be described.

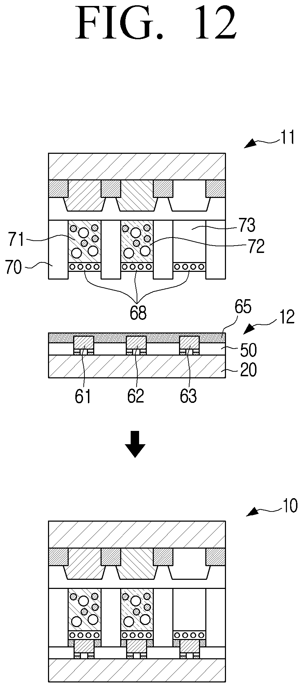

FIG. 12 is a process diagram of coupling a first portion and a second portion of a display module according to one or more embodiments.

In the operation S630 in FIG. 6, the first color conversion layer corresponds to the first self-luminescence element, and the second color conversion layer corresponds to the second self-luminescence element, and the manufacturing method may further include an operation of aligning the first substrate and the second substrate such that the transparent resin layer corresponds to the third self-luminescence element.

For example, referring to FIG. 12, after the second portion is seated on a die, the first portion is disposed on the upper side of the second portion at a specific interval.

Then, the first portion 11 is reversed for bonding the first and second portions 11, 12 with each other, and the first portion 11 is aligned in a bonding position such that the first and second color conversion layers 71, 72 of the first portion correspond to the first and second micro LEDs 61, 62 of the second portion, and the first transparent resin layer 73 corresponds to the third micro LED 63.

In this case, the first and second portions 11, 12 may be disposed to be maintained parallel with each other for the same plane.

After the first and second portions 11, 12 are aligned in a bonding position, the first portion 11 is made to adjoin the second portion 12 by predetermined pressure, and the first and second portions 11, 12 are bonded with each other. In this case, the first and second portions 11, 12 are attached to each other by the optical adhesive 65.

After the first and second portions 11, 12 are bonded with each other, the optical adhesive 65 may be cured, and the coupling between the first and second portions 11, 12 may thereby be secured.

Through the process as above, the display module 10 according to one or more embodiments may be manufactured.

In the above, each of the various embodiments of the disclosure was described independently, but each embodiment does not necessarily have to be implemented solely, but the components and the operations of each embodiment may be implemented in combination with those of at least one other embodiment.

Also, in the above, embodiments have been shown and described, but the disclosure is not limited to the aforementioned embodiments, and it is apparent that various modifications may be made by those having ordinary skill in the technical field to which the disclosure belongs, without departing from the gist of the disclosure as claimed by the appended claims and their equivalents. Further, it is intended that such modifications are not to be interpreted independently from the technical idea or prospect of the disclosure.

## Claims

1. A display module comprising:
a substrate; and
a plurality of pixels on the substrate,
wherein each of the plurality of pixels comprises:
a first self-luminescence element, a second self-luminescence element, and a third self-luminescence element configured to emit lights of a first wavelength band, respectively;
a first color conversion layer configured to be disposed on the first self luminescence element, and comprise a plurality of first quantum dots to absorb the light of the first wavelength emitted from the first self-luminescence element, and emit a light of a second wavelength band; and
a second color conversion layer configured to be disposed the second self luminescence element, and comprise a plurality of second quantum dots to absorb the light of the first wavelength emitted from the second self-luminescence element, and emit a light of a third wavelength band,
wherein the first color conversion layer and the second color conversion layer comprise a plurality of foam particles configured to scatter the light emitted from the first self-luminescence element and the light emitted from the second self-luminescence element.

2. The display module of claim 1, wherein a diameter of each foam particle among the plurality of foam particles is between 0.74 µm and 1.26 µm.

3. The display module of claim 1, wherein the plurality of foam particles are foam particles of an inert gas.

4. The display module of claim 1, wherein a volume fraction of the plurality of foam particles for each of the first color conversion layer and the second color conversion layer is between 5.3 % and 9 %.

5. The display module of claim 1, wherein each of the first color conversion layer and the second color conversion layer further comprise a plurality of scattering particles.

6. The display module of claim 5, wherein a mass ratio of the plurality of first quantum dots and the plurality of scattering particles included in the first color conversion layer is between 1:0.04 and 1:0.14, and
wherein a mass ratio of the plurality of second quantum dots and the plurality of scattering particles included in the second color conversion layer is between 1:0.04 and 1:0.14.

7. The display module of claim 1, wherein the first self-luminescence element, the second self-luminescence element, and the third self-luminescence element are blue micro light emitting diodes.

8. The display module of claim 7, wherein the plurality of first quantum dots are configured to absorb a light of a blue wavelength band and emit a light of a red wavelength band, and
wherein the plurality of second quantum dots are configured to absorb a light of a blue wavelength band and emit a light of a green wavelength band.

9. The display module of claim 1, further comprising:
a first color filter on the first color conversion layer; and
a second color filter on the second color conversion layer.

10. The display module of claim 9, further comprising:
a first transparent resin layer on the third self-luminescence element; and
a second transparent resin layer on the first color conversion layer,
wherein the second transparent resin layer, the first color filter, and the second color filter are on a same plane.

11. A manufacturing method of a display module, the method comprising:
forming a first self-luminescence element, a second self-luminescence element, and a third self-luminescence element corresponding to a plurality of sub-pixels on a first substrate;
forming a first color conversion layer and a second color conversion layer comprising a plurality of foam particles in areas corresponding to the first self-luminescence element and the second self-luminescence element among areas partitioned by a plurality of partitions formed on a second substrate;
forming a transparent resin layer in an area corresponding to the third self-luminescence element among the areas partitioned by the plurality of partitions; and
bonding the first substrate and the second substrate to each other, and bonding the plurality of color conversion layers to the first and second self-luminescence elements, and bonding the transparent resin layer to the third self-luminescence element,
wherein the first color conversion layer comprises a plurality of first quantum dots configured to absorb a light of a first wavelength emitted from the first self-luminescence element, and emit a light of a second wavelength band,
wherein the second color conversion layer comprises a plurality of second quantum dots configured to absorb a light of the first wavelength emitted from the second self-luminescence element and emit a light of a third wavelength band, and
wherein the light emitted from the first self-luminescence element and the light emitted from the second self-luminescence element are scattered by a plurality of foam particles included in the first color conversion layer and the second color conversion layer.

12. The manufacturing method of claim 11, further comprising:
forming a plurality of black matrices at predetermined intervals on the second substrate;
forming color filters among the plurality of black matrices formed on the second substrate; and
forming partitions on each black matrix among the plurality of black matrices to correspond to the plurality of sub-pixels.

13. The manufacturing method of claim 11, further comprising bonding the first substrate and the second substrate to each other such that the first color conversion layer corresponds to the first self-luminescence element, the second color conversion layer corresponds to the second self-luminescence element, and the transparent resin layer corresponds to the third self-luminescence element.

14. The manufacturing method of claim 11, wherein a diameter of each foam particle among the plurality of foam particles is between 0.74 µm and 1.26 µm.

15. The manufacturing method of claim 11, wherein the plurality of foam particles are foam particles of an inert gas.
